# EUROPÄISCHE PATENTSCHRIFT

(11) **EP 2 149 035 B1**
(45) Veröffentlichungstag und Bekanntmachung des Hinweises auf die Patenterteilung: **06.08.2014**
(21) Anmeldenummer: 08758507.1
(22) Anmeldetag: 14.05.2008
(51) Int. Cl.: G01D 5/14

(54) **VORRICHTUNG ZUM ERFASSEN EINES STELLWINKELS EINES UM EINE ACHSE DREHBAREN ELEMENTES**
DEVICE FOR THE DETECTION OF AN ACTUATION ANGLE OF AN ELEMENT ROTATABLE ABOUT A SHAFT
DISPOSITIF DESTINÉ À SAISIR UN ANGLE DE RÉGLAGE D'UN ÉLÉMENT PIVOTANT AUTOUR D'UN AXE

(30) Priorität: 18.05.2007 DE 102007024249
(43) Veröffentlichungstag der Anmeldung: 03.02.2010
(73) Patentinhaber: DeltaTech Controls USA, LLC, Newton, MA 02458 (US)
(72) Erfinder: EHLEBRECHT, Jörg, 10779 Berlin (DE); LÜDTKE, Thomas, 13509 Berlin (DE); KOSCHKE, Henning, 10115 Berlin (DE); BUCHHOLD-TOMAZIC, Christian, 16515 Oranienburg (DE)
(74) Vertreter: DREISS Patentanwälte PartG mbB
(86) Internationale Anmeldenummer: PCT/EP2008/003853
(87) Internationale Veröffentlichungsnummer: WO 2008/141758

(56) Entgegenhaltungen:
- WO-A-00/04339
- US-A1- 2006 006 861

## Beschreibung

Die vorliegende Erfindung bezieht sich auf eine Vorrichtung zum Erfassen eines Stellwinkels von mehr als 180° eines um eine Achse dreh- bzw. schwenkbaren Elementes nach dem Oberbegriff des Anspruchs 1.

Aus der DE 101 33 492 A1 ist eine Vorrichtung zum Erfassen eines Stellwinkels eines um eine Achse dreh- bzw. schwenkbaren Elementes in Form eines Fußpedals bekannt, dessen Permanentmagneten zwei Hallsensoren einer Hallsensoranordnung derart zugeordnet sind, dass die Schwenkbewegung des Fußpedals in die eine Richtung vom einen Hallsensor als positive Winkelbewegung und diejenige in die andere Richtung vom anderen Hallsensor als negative Winkelbewegung erkannt wird. Dabei liegen die beiden Hallsensoren zu beiden Seiten der Polteilung des ringförmigen Permanentmagneten, so dass jeder Hallsensor nur innerhalb eines Winkelbereichs von < 90° von der Polteilung entfernt ist.

Bei dieser bekannten Vorrichtung kann somit nur ein begrenzter Winkelbereich von ± < 90° erfasst und ausgewertet werden. bies ist für bestimmte Anwendungen nicht ausreichend.

Aus der US 2006/006861 A1 ist bei einer Vorrichtung zum Erfassen eines Stellwinkel von mehr als 180° eines um eine Achse dreh- bzw. schwenkbaren Elementes der eingangs genannten Art die Sensorvorrichtung entweder durch eine AMR-Sensoreinheit oder durch eine GMR-Sensoreinheit gebildet, der axial gegenüberliegend ein scheibenförmiger Permanentmagnet angeordnet ist, der mit einer Welle verbunden ist.

Aus der WO 00/04339 A ist ein bürstenloser elektrischer Motor mit zwei senkrechten Hall-Wandlern bekannt, der mehrere über den Umfang eines Erfassungsringes angeordnete Permanentmagnete aufweist. Die beiden Hall-Sensoren werden dabei in der weise eingesetzt und bewertet, dass die Signalform der Hall-Sensoren nur zwischen einem oberen und einem unteren Schwellenwert betrachtet wird.

Aufgabe der vorliegenden Erfindung ist es deshalb, eine alternative Vorrichtung zum Erfassen eines Stellwinkels eines um eine Achse dreh- bzw. schwenkbaren Elementes der eingangs genannten Art zu schaffen, bei der auch ein Stellwinkel von über 90° in dieselbe Richtung und insbesondere ein solcher von mehr als 180° erfasst werden kann.

Zur Lösung dieser Aufgabe sind bei einer Vorrichtung zum Erfassen eines Stellwinkels eines um eine Achse dreh- bzw. schwenkbaren Elementes der genannten Art die im Anspruch 1 angegebenen Merkmale vorgesehen.

Durch die erfindungsgemäßen Maßnahmen ist es möglich, einen Winkel von mehr als 180° auszuwerten, da mehrere Sensoren über den Umfang des ringförmigen Permanentmagneten verteilt sind. Dabei wird jeweils das Signal desjenigen Hallsensors, der im günstigsten Bereich seiner Kennlinie ist, verwendet, wobei der Mikrocontroller bzw. dessen elektronische Schaltung entscheidet, welcher der Hallsensoren in einem bestimmten Winkelbereich als aktiv ausgewählt und gewertet ist. Durch die Anordnung von drei statt zwei Hallsensoren ist es darüber hinaus möglich, eine komplette Drehung von 360° des drehbaren Elementes auszuwerten. Darüber hinaus kann ein weiterer Sensor angeordnet werden, wenn die Auswertung redundant sein soll. Eine bevorzugte Ausgestaltung der Auswählbarkeitskriterien durch den Mikrocontroller hierzu ergibt sich aus den Merkmalen des Anspruchs 2 und ggf. denen des Anspruchs 3.

Eine zweckmäßige und herstellungstechnisch vorteilhafte Ausgestaltung der Vorrichtung ergibt sich nach den Merkmalen eines oder mehrer der Ansprüche 4 sowie ggf. 5 bis 7.

Vorteilhafte Ausgestaltungen des Sensorhalters ergeben sich aus den Merkmalen eines oder mehrerer der Ansprüche 8 bis 11.

Mit den Merkmalen nach Anspruch 12 und ggf. denen des Anspruchs 13 ist erreicht, dass eine derartige Positionierung der Hallsensoren gegenüber einer Zuordnung jeweils einer separaten Platine zu jedem Hallsensor einfacher ist.

Weitere Einzelheiten der Erfindung sind der folgenden Beschreibung zu entnehmen, in der die Erfindung anhand des in der Zeichnung dargestellten Ausführungsbeispieles näher beschrieben und erläutert ist. Es zeigen:

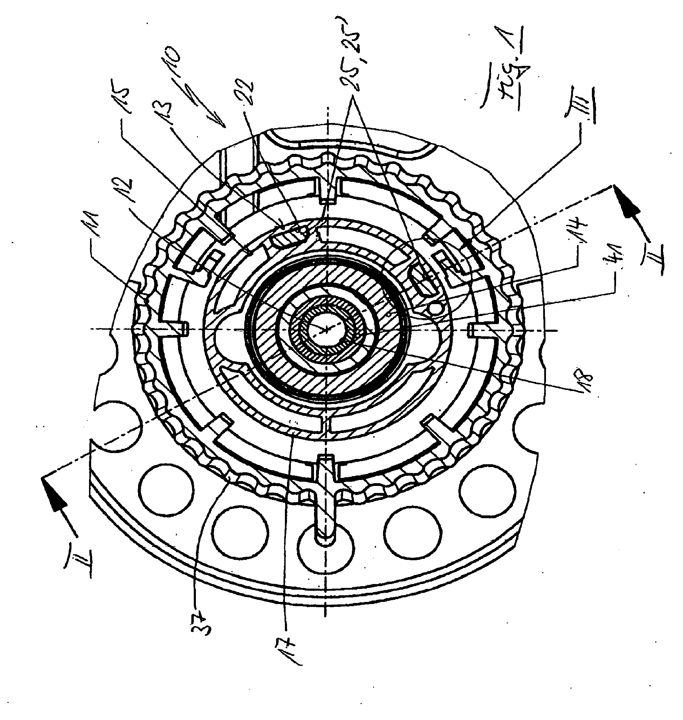

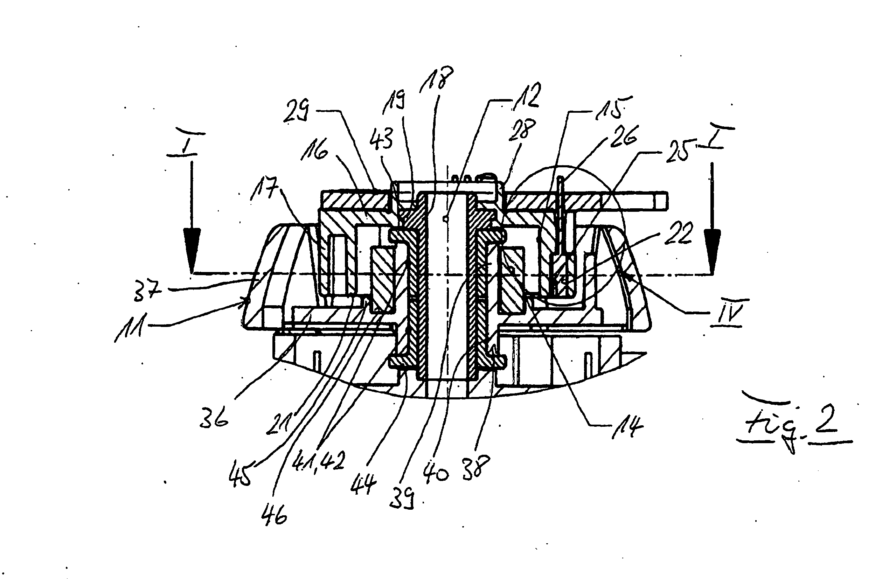

- Figur 1: in einer parallel zur Draufsicht geschnittenen Darstellung längs der Linie I-I der Figur 2 eine Vorrichtung mit zwei Sensoren zum Erfassen eines Stellwinkels von mehr als 180° eines um eine Achse drehbaren Eingabeelementes gemäß einem bevorzugten Ausführungsbeispiel vorliegender Erfindung,
- Figur 2: einen Schnitt längs der Linie II-II der Figur 1,

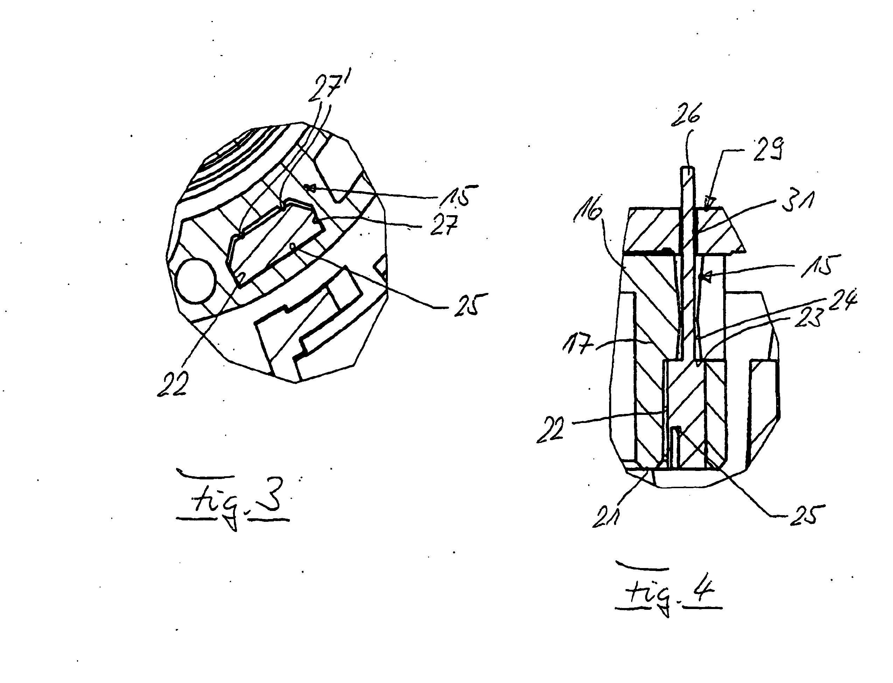

- Figur 3: eine vergrößerte Ausschnittsdarstellung gemäß Kreis III der Figur 1,
- Figur 4: eine vergrößerte Ausschnittsdarstellung gemäß Kreis IV der Figur 2 und
- Figur 5: ein Diagramm der analog digital gewandelten Signalspannung der beiden Sensoren sowie der daraus ausgewählten analog/digital gewandelten Ausgangsspannung in Abhängigkeit vom Stellwinkel.

Die in der Zeichnung dargestellte Vorrichtung 10 dient beispielsweise für Arimlehnen an Traktoren oder für eine Ausgangswelle zum Ankoppeln von landwirtschaftlichen Geräten an Traktoren zum Einstellen und Erfassen eines Stellwinkels von mehr als 90° oder 180° und mehr in dieselbe Drehrichtung eines um eine Achse 12 drehbaren Elementes 11, das hier als Eingabeelement 11 bezeichnet wird. Das Einstellen und Erfassen des Stellwinkels erfolgt über eine aus einer Hallsensoranordnung 13 bestehenden Magnetfeld-Sensorvorrichtung und einem ringförmigen Permanentmagneten 14, wodurch das zu betreibende und in seinem Stellwinkel verstellbare Bauelement in nicht dargestellter Weise angetrieben bzw. verstellt wird. Während der einzige ringförmige Permanentmagnet 14 am radförmigen Eingabeelement 11 angeordnet ist, ist die Hallsensoranordnung 13 an einem Sensorhalter 15 gehalten, gegenüber dem das radförmige Eingabeelement 11 konzentrisch um einen Winkel von > 90° oder von > 180° (beim dargestellten Ausführungsbeispiel von 210° bis 220°) in dieselbe Richtung und dabei beispielsweise auch um bis zu 360° verdrehbar ist.

Der auf dem Kopf stehende, etwa topfförmige Sensorhalter 15 ist einstückig aus Kunststoff aus einem Boden 16 und einem umlaufenden Mantel 17 gebildet. Der Boden 16 des Sensorhalters 15 ist mittig von einer hohlen metallischen Achse 18 durchdrungen und mit der Achse 18 dadurch drehfest verbunden, dass ein radialer Flansch 19 der hohlen Achse 18 vom Boden 16 umspritzt ist. Dadurch wird eine genaue Positionierung der hohlen Achse 18, die vorzugsweise aus Stahl ist, zum Sensorhalter 15 erreicht.

Der Mantel 17 des Sensorhalters 15 besitzt beim Ausführungsbeispiel zwei in winkligem Abstand von etwas weniger als 90°, hier von 80°, zueinander angeordnete und von seiner axialen Mantelfläche 21 ausgehende Ausnehmungen 22, die in axialer Richtung über eine Ringschalterfläche 23 in eine durchmesserkleinere Durchgangsbohrung 24 übergehen. In diese Ausnehmungen 22 bzw. Kammern ist jeweils ein einzelner Hallsensor 25 bzw. 25' der Hallsensoranordnung 13 eingesetzt, dessen Anschlussbeine 26 die Durchgangsbohrung 24 durchdringen und aus dem Boden 16 herausragen. Jeder Hallsensor 25, 25' ist in der Ausnehmung 22 positionsgenau gelagert und zwar dadurch, dass die Ausnehmungen bzw. Kammern 22, die beim Ausführungsbeispiel etwa trapezförmig im Querschnitt sind, an zwei zueinander senkrechten Seitenflächen mit Quetschrippen 27, 27' versehen sind, zwischen denen der Hallsensor 25, 25' gehalten ist. Dadurch wird der Hallsensor 25, 25' stets in die gleiche Ecke der Kammer 22 gedrückt. Beim Ausführungsbeispiel besitzt die eine kurze Seite der Kammer 22 eine einzige Quetschrippe 27, während die dazu rechtwinklig verlaufende lange Seite mit zwei im Abstand angeordneten Quetschrippen 27' versehen ist. Es versteht sich, dass die Anzahl der Quetschrippen 27, 27' bzw. der Querschnitt der Kammer 22 in anderer Weise ausgestaltet sein kann.

Am Boden 16 des Sensorhalters 15 liegt den Kammern 22 abgewandt eine gedruckte Leiterplatte bzw. Platine 29, die mittig um einen axialen Ringflansch des Bodens 16 angeordnet ist. Die Platine 29 ist mit dem Boden 16 fest verbunden. Durch elektrisch leitende Bohrungen 31 der Platine 29 sind die Anschlussbeine 26 des Hallsensors 25, 25' gesteckt und verlötet. Damit wird über die gemeinsame Platine 29 die elektrische Beschaltung der Hallsensoren 25, 25' erreicht.

Wenn auch beim Ausführungsbeispiel lediglich zwei Hallsensoren 25 und 25' in einem winkligen Abstand von etwas weniger als 90°, d.h. hier von 80° angeordnet sind, versteht es sich, dass über den Umfang der Mantelfläche 21 in einer entsprechenden Mehrzahl von Kammern 22 drei oder vier Hallsensoren 25 angeordnet bzw. vorgesehen sein können. Mit gemäß dem Ausführungsbeispiel zwei Hallsensoren 25, 25' kann ein Winkelbereich von etwa 210° bis 220° und mit drei Hallsensoren ein Winkelbereich von 360° abgedeckt werden. Eine redundante Auswertung des Stellwinkels von 360° kann durch vier Hallsensoren 25 erreicht werden.

Das radförmige Eingabeelement 11 besitzt einen Boden 36 und eine Handhabe 37, die aus Kunststoff einstückig sind. Die Handhabe 37 ist nach Art einer sich konisch gewölbt von unten nach oben verjüngenden Mantelfläche ausgebildet, die zum Umgreifen des Sensorhalters 15 diesem zugewandt offen ist.

Der Boden 36 besitzt einstückig eine Innenhülse 38, die axial zu beiden Seiten des Bodens 36 vorragt, wobei der innerhalb der Handhabe 37 befindende Hülsenabschnitt 39 länger ist als der Hülsenabschnitt 40, der der Handhabe 37 abgewandt ist. Die zentrische Innenhülse 38 ist an ihrer Innenfläche von zwei Gleitbuchsen 41 und 42 eingefasst. Die beiden identischen Gleitbuchsen 41 und 42 besitzen längs der Innenhülse 38 mittig einen axialen Abstand und übergreifen die Ringstirnflächen der Hülseabschnitte 39 und 40 mit ihrem jeweiligen axial nach außen ragenden Ringflansch 43 bzw. 44. Für eine optimale Lagerung sind die beiden Gleitbuchsen 41, 42 in bzw. über die Innenhülse 38 gepresst.

Zwischen der den Gleitbuchsen 41, 42 abgewandten Umfangsfläche der Innenhülse 38 und einem radial äußeren vom Boden axial vorstehenden Ringflansch 45 ist der Permanentmagnet 14 in Form eines Ringmagnetes angeordnet und gehalten. Der ringförmige Permanentmagnet 14 ist dabei in eine Ringvertiefung des Bodens 36 eingesetzt und zentriert eingeklebt. Der Ringmagnet erstreckt sich bis nahe an die Ringstirnfläche des oberen längeren Hülsenabschnitts 39.

Das Eingabeelement 11 ist mit den beiden Gleitbuchsen 41 und 42 auf der hohlen Achse 18 mit sehr geringem Spiel drehbar gelagert. Dies wird auch dadurch erreicht, dass die beiden Gleitbuchsen 41 und 42 aus gesinterten Bronzebuchsen bestehen, die in Kombination mit der hohlen Achse 18 aus Stahl zu dieser sehr spielarmen Lagerung führen.

Durch das axiale Ineinandergreifen von Eingabeelement 11 und Sensorhalter 15 und die entsprechende Anordnung von Permanentmagnet 14 und Hallsensoren 25, 25' ist eine genaue Zuordnung sowohl in radialer als auch in axialer Richtung gegeben, indem die Hallsensoren 25, 25' radial in einem feststehenden Abstand und axial etwa in mittiger Höhe des ringförmigen Permanentmagneten 14 angeordnet sind.

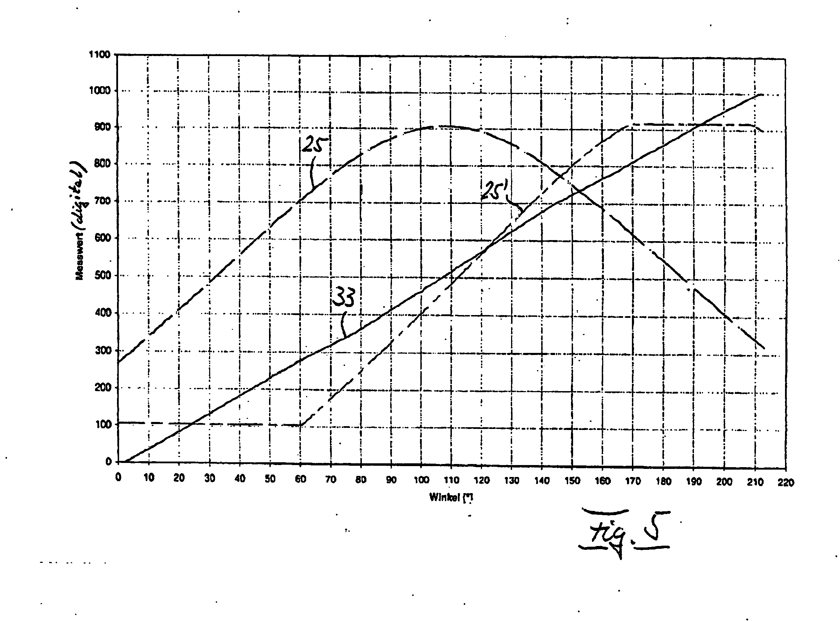

In nicht dargestellter Weise ist vorzugsweise auf der Platine 29 ein Mikrocontroller vorgesehen, mit dessen Hilfe für die aktuelle Stellung des radförmigen Eingabeelementes 11 der jeweils lagegünstigste Hallsensor 25 bzw. 25' ausgewählt wird, um den betreffenden Stellwinkel genau zu erfassen. Damit wird entschieden, welcher der beiden Hallsensoren 25, 25' jeweils aktiv ist bzw. sein soll. Dies heißt gemäß der Darstellung der Kennlinien (digital gewandelte Signalspannung in Abhängigkeit vom Stellwinkel) der Sensoren 25 (gestrichelt) und 25' (strichpunktiert) in Figur 5, dass vom Mikrocontroller nacheinander jeweils derjenige Hallsensor 25, 25' ausgewählt wird, dessen Kennlinie 33 (in ausgezogener Linie), beim entsprechenden Stellwinkel im linearen Bereich ist, so dass die resultierenden, daraus zusammengesetzte Gesamt- bzw. Ausgangskennlinie 33 im Stellwinkelbereich von hier etwa 210° bis 220° linear ist. Dabei kann auch, falls dies notwendig ist, durch Hin- und Herschalten, zum bzw. vom jeweiligen Hallsensor 25, 25' das jeweils linearste Verhalten erfasst werden. Beispielsweise ergibt sich die beste bzw. optimierte Linearität der Kennlinie 33 über den Winkelbereich von 210° bis 220° bei einem winkligen Abstand der beiden Hallsensoren 25 und 25' von 80°.

Der Mikrocontroller vermeidet außerdem, dass in den Übergangsbereichen, das heißt in den Umschaltpunkten von einem 25 auf den nächsten Hallsensor 25' oder umgekehrt, ein Sprung in der Ausgangskennlinie vorhanden ist. Es versteht sich, dass dies auch bei einem Stellwinkel von 360° bei drei oder vier Hallsensoren gilt.

## Patentansprüche

1. Vorrichtung (10) zum Erfassen eines Stellwinkels von mehr als 180° eines um eine Achse (18) dreh- bzw. schwenkbaren Elementes (11), mit einer Sensorvorrichtung (13), die in Abhängigkeit vom Drehwinkel ein elektrisches Signal abgibt und die einen mit dem dreh- bzw. schwenkbaren Element (11) bewegungsfest verbundenen Permanentmagneten (14) aufweist, **dadurch gekennzeichnet, dass** die Sensorvorrichtung eine ortsfeste Hallsensoranordnung (13) aufweist, die zwei oder mehr in winkligem Abstand um den einzigen ringförmigen und diametral magnetisierten Permanentmagneten (14) angeordnete einzelne Hallsensoren (25) aufweist, von denen entsprechend der aktuellen Stellung des dreh- bzw. schwenkbaren Elementes (11) der jeweils im linearen Bereich seiner Kennlinie liegende Hallsensor (25) von einem Mikrocontroller ausgewählt ist, und dass ein Sensorhalter (15) vorgesehen ist, der in ungleichmäßig winkligem Abstand mit Kammern (22) zur Aufnahme der Hallsensoren (25) versehen ist.

2. Vorrichtung nach Anspruch 1, **dadurch gekennzeichnet, dass** vom Mikrocontroller nacheinander jeweils derjenige Hallsensor (25) auswählbar ist, dessen Kennlinie im linearen bzw. linearsten Bereich ist, so dass die resultierende, daraus zusammengesetzte Gesamt- bzw. Ausgangskennlinie während eines Stellwinkelbereichs von 0° bis 360° linear verbleibt bzw. ist.

3. Vorrichtung nach Anspruch 2, **dadurch gekennzeichnet, dass** bei einem maximalen Stellwinkelbereich von etwa 210° bis 220° zwischen den linearen Kennlinien von zwei Hallsensoren (25, 25') ausgewählt ist, die in einem Winkel von 80° auseinanderliegen.

4. Vorrichtung nach mindestens einem der Ansprüche 1 bis 3, **dadurch gekennzeichnet, dass** die Sensoranordnung (13) um den Permanentmagneten (14) vorzugsweise ungleichmäßig winklig verteilt angeordnete Hallsensoren (25) aufweist.

5. Vorrichtung nach mindestens einem der Ansprüche 1 bis 4, **dadurch gekennzeichnet, dass** das dreh- bzw. schwenkbare Element (11) über eine vorzugsweise axial geteilte Gleitbuchse (41, 42) an der Achse (18) gelagert ist, wobei die Achse (18) aus Stahl und die Gleitbuchse (41, 42) aus Bronze ist.

6. Vorrichtung nach mindestens einem der vorhergehenden Ansprüche, **dadurch gekennzeichnet, dass** das dreh- bzw. schwenkbare Element (11) mit dem vorzugsweise einzigen Permanentmagneten (14) versehen ist, vorzugsweise klebend verbunden ist.

7. Vorrichtung nach Anspruch 6, **dadurch gekennzeichnet, dass** das dreh- bzw. schwenkbare Element (11) einen Ringflansch aufweist, dessen radiale Innenseite mit der Gleitbuchse (41, 42) verbunden und an dessen radialer Außenseite der Permanentmagneten (14) zentrierend gehalten ist.

8. Vorrichtung nach Anspruch 1, **dadurch gekennzeichnet, dass** der Hallsensor (25) in der betreffenden Kammer (22) des Sensorhalters (15) in Position gehalten ist.

9. Vorrichtung nach Anspruch 8, **dadurch gekennzeichnet, dass** in der Kammer (22) an vorzugsweise zwei Seiten Quetschrippen (27, 27') vorgesehen sind.

10. Vorrichtung nach Anspruch 8 oder 9, **dadurch gekennzeichnet, dass** der Sensorhalter (15) mit der Achse (18) fest verbunden ist und vorzugsweise ein Flansch (19) der Achse (18) vom Sensorhalter (15) umspritzt ist.

11. Vorrichtung nach mindestens einem der vorhergehenden Ansprüche, **dadurch gekennzeichnet, dass** der Sensorhalter (15) haubenförmig ausgebildet und mit seiner die Kammern (22) beinhaltenden Mantelfläche (21) radial zwischen den Permanentmagneten (14) und den Außenumfangsrand (37) des dreh- bzw. schwenkbaren Elementes bzw. Eingaberades (11) greift.

12. Vorrichtung nach mindestens einem der vorhergehenden Ansprüche, **dadurch gekennzeichnet, dass** eine gedruckte Leiterplatte bzw. Platine (29) vorgesehen ist, an der die Hallsensoren (25) mit ihren elektrischen Anschlüssen (26) gehalten sind.

13. Vorrichtung nach Anspruch 12, **dadurch gekennzeichnet, dass** die Anschlüsse bzw. Anschlussbeine (26) der Hallsensoren (25) durch den Sensorhalter (15) zur oberhalb dieses liegenden Platine (29) geführt sind.

## Claims

1. Device (10) for the detection of an actuation angle of more than 180° of an element (11) which is rotatable or pivotable about a shaft (18), comprising a sensor device (13) which emits an electrical signal depending on the rotation angle and a permanent magnet (14) that is non-movably connected to the rotatable or pivotable element (11), **characterised in that** the sensor device has a locally fixed Hall sensor arrangement (13) which comprises two or more individual Hall sensors (25) arranged at an angular distance round the single annular, diametrically magnetisable permanent magnet (14), of which the Hall sensor (25) located in the linear region of the characteristic thereof, depending on the current position of the rotatable or pivotable element (11), is selected by a microcontroller, and that a sensor holder (15) is provided which has chambers (22) at unequal angular distances for receiving the Hall sensors (25).

2. Device according to claim 1, **characterised in that**, one after the other, the Hall sensor (25) the characteristic of which is in the linear or the most linear region can be selected by the microcontroller, so that the resulting overall or starting characteristic line assembled therefrom remains or is linear throughout an actuation angle range from 0° to 360°.

3. Device according to claim 2, **characterised in that**, with a maximum actuation angle range of approximately 210° to 220°, the selection is made between the characteristics of two Hall sensors (25, 25') which are separated by an angle of 80°.

4. Device according to at least one of the claims 1 to 3, **characterised in that** the sensor arrangement (13) round the permanent magnet (14) comprises Hall sensors (25) distributed preferably at unequal angles.

5. Device according to at least one of the claims 1 to 4, **characterised in that** the rotatable or pivotable element (11) is mounted on the shaft (18) via a preferably axially divided slide bush (41, 42), wherein the shaft (18) is made of steel and the slide bush (41, 42) is made of bronze.

6. Device according to at least one of the preceding claims, **characterised in that** the rotatable and pivotable element (11) is provided with the preferably single permanent magnet (14), preferably adhesively connected thereto.

7. Device according to claim 6, **characterised in that** the rotatable or pivotable element (11) comprises an annular flange, the radially interior side of which is connected to the slide bush (41, 42) and at the radially exterior side of which the permanent magnet (14) is held in a centering manner.

8. Device according to claim 1, **characterised in that** the Hall sensor (25) is held in position in the relevant chamber (22) of the sensor holder (15).

9. Device according to claim 8, **characterised in that** compression ribs (27, 27') are provided in the chamber (22), preferably at two sides.

10. Device according to claim 8 or 9, **characterised in that** the sensor holder (15) is firmly connected to the shaft (18) and preferably the sensor holder (15) is injection moulded round a flange (19) of the shaft (18).

11. Device according to at least one of the preceding claims, **characterised in that** the sensor holder (15) is configured hood shaped and engages with the outer surface (21) thereof containing the chambers (22) radially between the permanent magnet (14) and the exterior peripheral edge (37) of the rotatable or pivotable element or input wheel (11).

12. Device according to at least one of the preceding claims, **characterised in that** a printed circuit board or card (29) is provided on which the Hall sensors (25) are held by the electrical terminals (26) thereof.

13. Device according to claim 12, **characterised in that** the terminals or terminal posts (26) of the Hall sensors (25) are guided through the sensor holder (15) to the circuit board (29) arranged thereabove.

## Revendications

1. Dispositif (10) pour détecter un angle de positionnement de plus de 180° d'un élément (11) capable de tourner ou de basculer autour d'un axe (18), comprenant un dispositif capteur (13) qui délivre un signal électrique en fonction d'un angle de rotation et qui comprend un aimant permanent (14) relié solidaire des déplacements de l'élément (11) capable de tourner ou de basculer,
**caractérisé en ce que**
le dispositif capteur comprend un agencement capteur de Hall (13) stationnaire, qui comprend deux ou plusieurs capteurs de Hall (25) individuels agencés à distance angulaire dans l'unique aimant permanent (14) de forme annulaire et présentant une aimantation diamétrale, parmi lesquels le capteur de Hall (25) situé respectivement dans la zone linéaire de sa courbe caractéristique en correspondance de la position actuelle de l'élément (11) capable de tourner ou de basculer est sélectionné par un microcontrôleur, et **en ce qu'**il est prévu un porte-capteur (15) qui est doté de chambres (22) pour loger les capteurs de Hall (25) à des distances angulaires inégales.

2. Dispositif selon la revendication 1, **caractérisé en ce qu'**au moyen du microcontrôleur il est possible de sélectionner successivement et respectivement celui des capteurs de Hall (25) dont la courbe caractéristique est dans la plage linéaire ou la plus linéaire, de sorte que la courbe caractéristique résultant de totale ou de départ composé à partir de celles-ci reste linéaire ou est linéaire sur une plage angulaire de positionnement de 0° à 360°.

3. Dispositif selon la revendication 2, **caractérisé en ce que** pour une plage angulaire de positionnement maximale d'environ 210° à 220° il est fait une sélection entre les courbes caractéristiques linéaires de deux capteurs de Hall (25, 25') qui sont écartés à un angle de 80°.

4. Dispositif selon l'une au moins des revendications 1 à 3, **caractérisé en ce que** l'agencement capteur (13) comprend des capteurs de Hall (25) agencés autour de l'aimant permanent (14) et de préférence avec une répartition angulaire inégale.

5. Dispositif selon l'une au moins des revendications 1 à 4, **caractérisé en ce que** l'élément capable de tourner ou de basculer (11) est monté sur l'axe (18) au moyen d'un manchon coulissant (41, 42) de préférence subdivisé axialement, l'axe (18) étant en acier et le manchon coulissant (41, 42) en bronze.

6. Dispositif selon l'une au moins des revendications précédentes, **caractérisé en ce que** l'élément capable de tourner ou de basculer (11) est doté de l'aimant permanent (14), de préférence unique, et de préférence relié par collage.

7. Dispositif selon la revendication 6, **caractérisé en ce que** l'élément capable de tourner ou de basculer (11) comprend une bride annulaire, dont le côté intérieur radial est relié au manchon coulissant (41, 42), et tel que l'aimant permanent (14) est maintenu centré au niveau de son côté extérieur radial.

8. Dispositif selon la revendication 1, **caractérisé en ce que** le capteur de Hall (25) est maintenu en position dans la chambre concernée (22) du porte-capteur (15).

9. Dispositif selon la revendication 8, **caractérisé en ce qu'**il est prévu des nervures de serrage (27, 27') dans la chambre (22), de préférence sur deux côtés.

10. Dispositif selon la revendication 8 ou 9, **caractérisé en ce que** le capteur de Hall (15) est relié fermement avec l'axe (18), et de préférence une bride (19) de l'axe (18) est entourée par le porte-capteur (15) à la manière d'un enrobage.

11. Dispositif selon l'une au moins des revendications précédentes, **caractérisé en ce que** le porte-capteur (15) est réalisé en forme de capot et, au moyen de sa surface enveloppe (21) qui inclut les chambres (22), il s'engage radialement entre les aimants permanents (14) et la bordure périphérique extérieure (37) de l'élément capable de tourner ou de basculer, ou respectivement de la roue d'entrée (11).

12. Dispositif selon l'une au moins des revendications précédentes, **caractérisé en ce qu'**il est prévu une carte ou une plaque à circuits imprimés (29) sur laquelle les capteurs de Hall (25) sont maintenus avec leurs connexions électriques (26).

13. Dispositif selon la revendication 12, **caractérisé en ce que** les connexions ou respectivement les pattes de connexion (26) des capteurs de Hall (25) sont passées à travers le porte-capteur (15) jusqu'à la plaque (29) située au-dessus de celui-ci.
